(19) **Europäisches Patentamt / European Patent Office / Office européen des brevets**

(11) **EP 3 690 898 A1**

(12) **EUROPEAN PATENT APPLICATION**
published in accordance with Art. 153(4) EPC

(43) Date of publication:
**05.08.2020 Bulletin 2020/32**

(21) Application number: **18860874.9**

(22) Date of filing: **28.09.2018**

(51) Int Cl.:
**H01B 1/22** (2006.01)     **H01B 1/00** (2006.01)
**H01L 21/288** (2006.01)     **H05K 1/09** (2006.01)

(86) International application number:
**PCT/JP2018/036253**

(87) International publication number:
**WO 2019/065965 (04.04.2019 Gazette 2019/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.09.2017   JP 2017192114
29.09.2017   JP 2017192115**

(71) Applicant: **Harima Chemicals, Inc.
Kakogawa-shi, Hyogo 675-0019 (JP)**

(72) Inventors:
• **NAKAJO Haruyuki
Tsukuba-shi
Ibaraki 300-2635 (JP)**

• **UEDA Masayuki
Tsukuba-shi
Ibaraki 300-2635 (JP)**
• **NAKATANI Makoto
Tsukuba-shi
Ibaraki 300-2635 (JP)**
• **HOSOYA Kazuo
Tsukuba-shi
Ibaraki 300-2635 (JP)**
• **IYANAGA Miki
Tsukuba-shi
Ibaraki 300-2635 (JP)**

(74) Representative: **Hübner, Gerd
Rau, Schneck & Hübner
Patentanwälte Rechtsanwälte PartGmbB
Königstraße 2
90402 Nürnberg (DE)**

(54) **ELECTROCONDUCTIVE PASTE**

(57) A conductive paste having high bondability to even a substrate which has low bondability to silver is provided. The conductive paste according to one embodiment of the present invention comprises: a silver particle having an average particle size within a range of 1 to 500 nm as a first average particle size; one or more metals selected from a group consisting of aluminum, titanium, vanadium, chromium, manganese, iron, cobalt, nickel, copper, zinc, zirconium, niobium, molybdenum, hafnium, tantalum, tungsten, indium, tin, gallium, germanium and bismuth; and an amine compound, wherein an amount of substance of the amine compound is equal to or more than an amount of substance of the metal.

Figure 1

EP 3 690 898 A1

**Description**

Technical Field

The present invention relates to a conductive paste.

Background Art

In recent years, particularly in a field of electronic material, a conductive paste in which metal particles such as a silver powder are stably dispersed has attracted attention. Since a metal thin film can be easily formed by applying a conductive paste on a substrate and heat-treating the conductive paste, a conductive paste is expected to be widely used for a bonding material, a wiring material, etc. (for example, see Patent Literature 1).

Citation List

Patent Literature

Patent Literature 1: Japanese Patent Laid-Open No. 2012-119132

Summary of Invention

Technical Problem

However, a conductive paste may cause the problem of bondability due to poor compatibility with a substrate. For example, a conductive paste comprising a silver powder as a main ingredient has low bondability to materials such as metals such as nickel, metal oxides such as aluminum oxide and indium tin oxide (ITO), metal nitrides such as aluminum nitride, glass, and semiconductor materials such as silicon, and thus cannot be used for these materials as substrates, which is a problem.

The present invention is proposed under these circumstances, and in one aspect, the object of the invention is to provide a conductive paste having high bondability to even a substrate which has low bondability to silver.

Solution to Problem

The conductive paste according to one embodiment of the present invention comprises: a silver particle having an average particle size within a range of 1 to 500 nm as a first average particle size; one or more metals selected from a group consisting of aluminum, titanium, vanadium, chromium, manganese, iron, cobalt, nickel, copper, zinc, zirconium, niobium, molybdenum, hafnium, tantalum, tungsten, indium, tin, gallium, germanium and bismuth; and an amine compound, wherein an amount of substance of the amine compound is equal to or more than an amount of substance of the metal.

Advantageous Effect of Invention

According to an embodiment of the present invention, in one aspect, a conductive paste having high bondability to even a substrate which has low bondability to silver can be provided.

Brief Description of Drawings

Figure 1 is a silver (Ag) - nickel (Ni) binary phase diagram.
Figure 2 is a silver (Ag) - zirconium (Zr) binary phase diagram.
Figure 3 is a zirconium (Zr) - nickel (Ni) binary phase diagram.
Figure 4 is a silver (Ag) - copper (Cu) binary phase diagram.
Figure 5 is a copper (Cu) - nickel (Ni) binary phase diagram.
Figure 6 is a diagram showing examples of a standard electrode potential of a simple substance.

Description of Embodiments

Hereinafter, the conductive paste according to one embodiment of the present invention will be described with reference to drawings.

In the present embodiment, a conductive paste comprises at least

a silver particle having an average particle size within a range of 1 to 500 nm as a first average particle size,
one or more metals selected from a group consisting of aluminum, titanium, vanadium, chromium, manganese, iron, cobalt, nickel, copper, zinc, zirconium, niobium, molybdenum, hafnium, tantalum, tungsten, indium, tin, gallium, germanium and bismuth, and
an amine compound,
wherein an amount of substance of the amine compound is equal to or more than an amount of substance of the metal. The conductive paste according to the present embodiment may further contain other components.

Usually, the conductive paste according to the present embodiment is applied to a substrate and heat-treated, and thus an inorganic dense sintered film can be obtained. In this case, since an organic component in the conductive paste is decomposed or removed by heat treatment, the conductive paste according to the present embodiment may contain an organic component.

Hereinafter, each component will be described in detail.

(Silver particle having a first average particle size)

The conductive paste according to the present embodiment comprises a silver particle having an average particle size within a range of 1 to 500 nm as an inorganic particle.

When the conductive paste according to the present embodiment is applied to, for example, formation of a wiring pattern in a field of electronic material, conductivity (resistance) of a whole sintered product of silver particles used for a conductive layer is predominantly governed by resistance of surfaces of silver particles coming into contact with each other. On the contrary, the conductivity of an individual silver particle itself is a subsidiary factor. Therefore, dense fusion and sintering is achieved by using a metal microparticle having an average particle size of 500 nm or less and having a clean metal surface exposed, due to its nano-size effect. Specifically, dense fusion and sintering is achieved at surfaces of silver particles during low temperature sintering treatment, by utilizing a phenomenon in which surface diffusion and movement of silver atoms actively proceed in the surface of a silver microparticle of nano-size even at a relatively low temperature. In order to utilizing this mechanism, a silver nanoparticle having an average particle size of 1 nm to 500 nm is preferably used.

Furthermore, preferable average particle size is varied depending on the kind of a foreign metal to be used. For example, when copper and/or bismuth is used as foreign metals, preferable average particle size of the silver particle is more than 100 nm and 500 nm or less. In other case, when manganese and/or titanium is used as foreign metals, preferable average particle size of the silver particle is 1 nm or more and less than 5 nm, or more than 20 nm and 500 nm or less.

The average particle size in the present embodiment refers to the particle size at a cumulated value of 50% in the particle size distribution (based on volume) measured by a laser diffraction method.

Usually, the above silver particle of nano-order has a particle size distribution. For the silver particle having a first average particle size, a silver particle having a monodispersed particle size as highly as possible is preferably used, and specifically, the particle having a polydispersity defined below within a range of 0.5 to 10 is preferably used.

$$\mathtt{Polydispersity\ =\ (D90\text{-}D10)/D50}$$

D10: diameter ($\mu$m) of silver particle at cumulated volume of 10%

D50: diameter ($\mu$m) of silver particle at cumulated volume of 50%

D90: diameter ($\mu$m) of silver particle at cumulated volume of 90%

Foreign metal

The foreign metal according to the present embodiment refers to a metal different from silver, and refers to a metal for enhancing bondability of the conductive paste according to the present embodiment to a substrate which has low bondability to silver. Specifically, it refers to a metal for enhancing bondability of the conductive paste to a material, such as metals such as nickel, metal oxides such as aluminum oxide and indium tin oxide (ITO), metal nitrides such as aluminum nitride, glass, and semiconductor materials such as silicon, which may serve as a substrate in a field of electronic material and has low bondability to a conductive paste containing silver as a main component.

Specific examples of foreign metals include one or more metals selected from a group consisting of aluminum, titanium, vanadium, chromium, manganese, iron, cobalt, nickel, copper, zinc, zirconium, niobium, molybdenum, hafnium, tantalum, tungsten, indium, tin, gallium, germanium and bismuth. The reason why these foreign metals are selected will be described below.

The form of a foreign metal present in the conductive paste is not particularly limited, and a foreign metal contained may be in the form of a metal particle (metal powder), or in the form of a compound such as metal oxide, metal salt and organic metal complex.

The mass of metal content of foreign metals in the conductive paste is preferably within a range of 0.001 to 5 mass% based on the mass of silver.

Next, the reason why the above foreign metals are selected will be described in detail.

Selection of Foreign Metal

Generally, when two materials A and B are bonded, bonding is easier as mutual diffusion between A and B more easily occurs. As specific examples in a field of electronic material, nickel, silicon, silicon carbide, and the like include an element difficult to mutually diffuse with silver, and therefore, a conductive paste containing silver as a main ingredient has low bondability to a substrate of nickel, silicon, silicon carbide, and the like.

Accordingly, the present inventors have selected aluminum, titanium, vanadium, chromium, manganese, iron, cobalt, nickel, copper, zinc, zirconium, niobium, molybdenum, hafnium, tantalum, tungsten, indium, tin, gallium, germanium and bismuth, as metals other than silver (foreign metals) which satisfy at least one or more of the three criteria below.

Criterion 1: An element which mutually diffuses (forms a solid solution or intermetallic compound) with both a substrate and silver;

Criterion 2: An element which has a lower standard electrode potential than a substrate and is capable of forming an alloy with silver;

Criterion 3: Elements including a first element having a lower standard electrode potential than a substrate, and a second element group having a standard electrode potential between the standard electrode potentials of silver and the first element, wherein the second element is capable of forming an alloy with both silver and the first element.

Specifically, when nickel, which has low bondability to silver, is used as a substrate, metals satisfying Criterion 1 among the above foreign metals are aluminum, titanium, manganese, copper, zinc, zirconium, indium, tin, bismuth, gallium and germanium; metals satisfying Criterion 2 are aluminum, titanium, manganese, zinc, zirconium, bismuth, indium and gallium; and for a combination of metals satisfying Criterion 3, the second element group is copper, chromium, indium and tin when the first element is, for example, manganese.

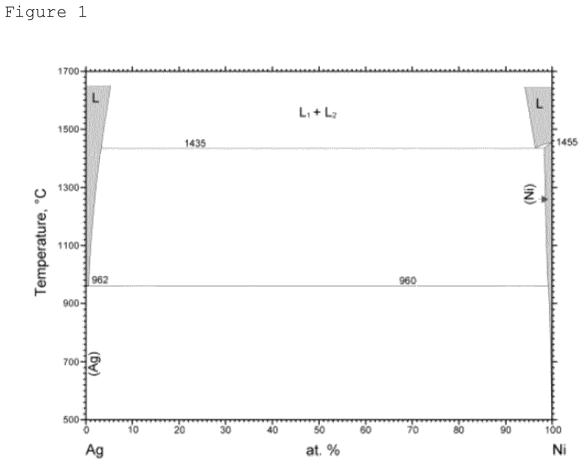

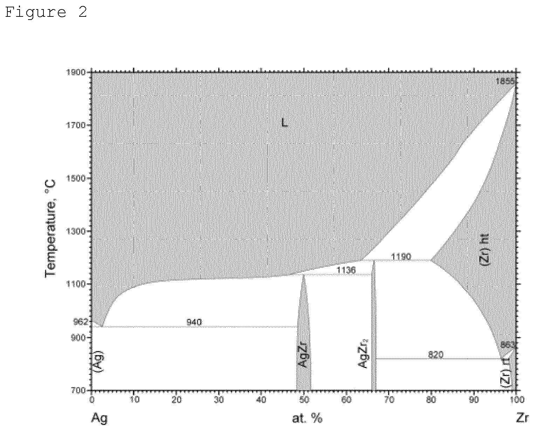

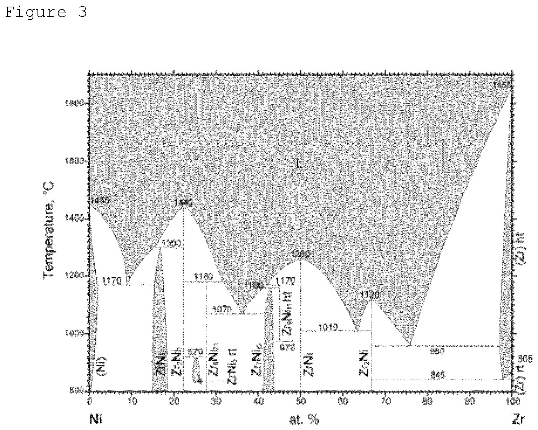

The reason why zirconium, for example, can be selected with regard to Criterion 1 in the case of using nickel as a substrate will be described below. Figure 1 shows a Ag - Ni binary phase diagram, Figure 2 shows a Ag - Zr binary phase diagram, and Figure 3 shows a Zr - Ni binary phase diagram. In a binary phase diagram, the horizontal axis shows the composition in molar fraction, and the vertical axis shows the temperature.

As shown in Figure 1, silver almost does not dissolve in nickel. However, as shown in Figure 2, zirconium can form an alloy with silver (intermetallic compound) such as AgZr and/or $AgZr_3$. Furthermore, as shown in Figure 3, zirconium can also form a plurality of intermetallic compound with nickel. Therefore, it is considered that when the conductive paste contains, for example, zirconium element as a foreign metal, bondability to a nickel substrate is also enhanced via for example a zirconium - silver based alloy and/or zirconium - nickel based alloy.

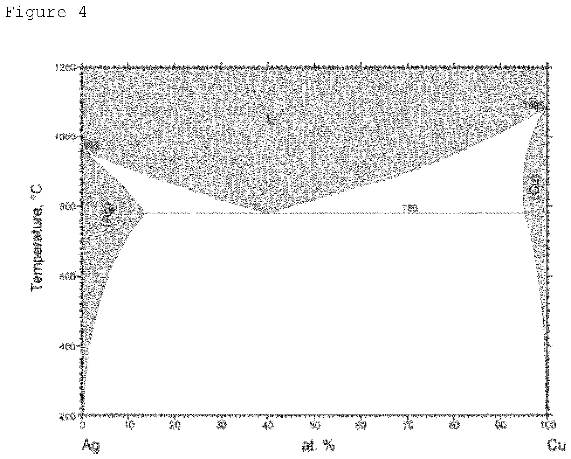

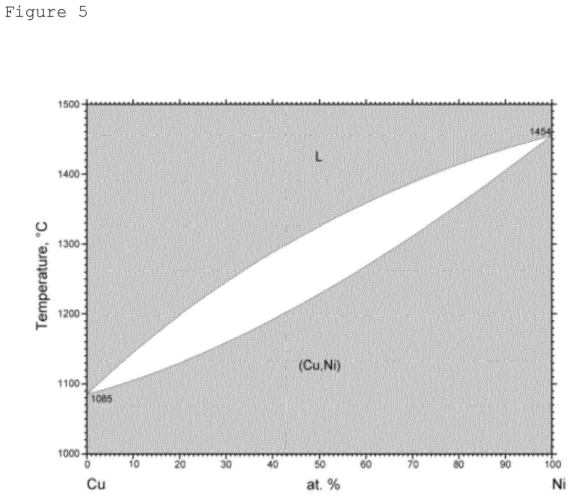

Similarly, the reason why copper, for example, can be selected with regard to Criterion 1 in the case of using nickel as a substrate will be described below. Figure 4 shows a Ag-Cu binary phase diagram, and Figure 5 shows a Cu-Ni binary phase diagram. In a binary phase diagram, the horizontal axis shows the composition in molar fraction, and the vertical axis shows the temperature.

As shown in Figure 1, silver almost does not dissolve in nickel. However, as shown in Figure 4, copper can form a solid solution with silver. Furthermore, as shown in Figure 5, copper and nickel form a solid solution at all proportions. Therefore, it is considered that when a conductive paste contains, for example, copper element as a foreign metal, the bondability of the conductive paste to a nickel substrate is also enhanced via, for example, a copper - silver alloy and/or copper - nickel alloy.

The reason why manganese, for example, can be selected with regard to Criterion 2 in the case of using nickel as a substrate will be described below.

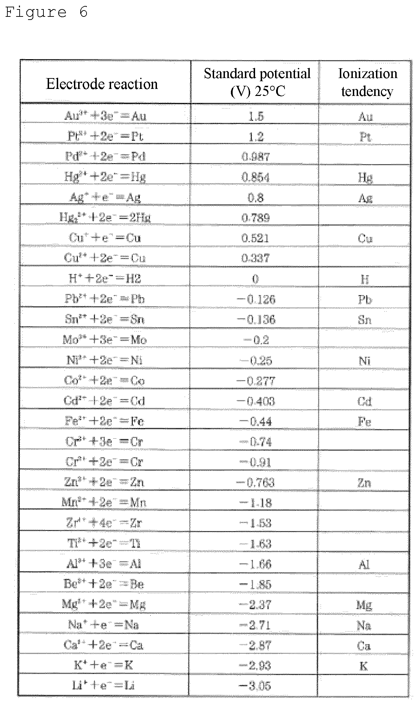

Figure 6 shows a diagram showing examples of a standard electrode potential of a metal simple substance.

A standard electrode potential is represented by the following formula when all chemical species participating in oxidation reaction are in the standard state:

$$E^0 = -\Delta G^0/nF = (RT/nF)\ln K$$

wherein $E^0$ is a standard electrode potential, $\Delta G^0$ is a change in standard Gibbs energy in the oxidation reaction, K is the equilibrium constant of the reaction, F is Faraday constant, T is an absolute temperature and n is the number of electrons participating in the oxidation reaction. Accordingly, since a standard electrode potential varies depending on temperature, standard electrode potentials at 25°C are adopted in Figure 6.

A standard electrode potential is generally used as an indicator representing reactivity of a metal simple substance in oxidation-reduction reaction. For example, as shown in Figure 6, manganese has a lower standard electrode potential than that of nickel, i.e., manganese undergoes oxidation more easily than nickel. Furthermore, manganese can form an alloy together with silver. Therefore, it is considered that when a conductive paste contains manganese element as a foreign metal, the bondability of the conductive paste to a nickel substrate is also enhanced via a silver - manganese alloy and/or manganese oxide (and nickel oxide). The standard electrode potential is an indicator representing reactivity of a metal element in oxidation-reduction reaction, and thus when an oxide or nitride was adopted as an intended substrate, a foreign metal was selected based on the standard electrode potentials of the constituent metal elements.

By the above described method, the present inventors have selected aluminum, titanium, vanadium, chromium, manganese, iron, cobalt, nickel, copper, zinc, zirconium, niobium, molybdenum, hafnium, tantalum, tungsten, indium, tin, gallium, germanium and bismuth as foreign metals satisfying any one of Criterion 1, Criterion 2 and Criterion 3, for substrates which are difficult to bond to silver, for example, metals such as nickel, metal oxides such as aluminum oxide and indium tin oxide (ITO), metal nitrides such as aluminum nitride, glass, and semiconductor materials such as silicon.

Amine Compound

The conductive paste according to the present embodiment further comprises an amine compound. The content of the amine compound in the conductive paste is selected so that the amount of substance of the amine compound is equal to or more than the amount of substance of the foreign metal described above. The content of the amine compound in the conductive paste means a total amount of an amine compound coating a silver particle having a first average particle size and that coating a silver particle having a second average particle size, and a free amine compound in the system.

When the amount of substance of the amine compound in the conductive paste is equal to or more than the amount of substance of the foreign metal, the foreign metal is easy to dissolve in the system even in the case where any of polar solvents and non-polar solvents is used as a solvent. Therefore, the effect obtained by adding the foreign metal described above (enhancement of bondability) can be exhibited more effectively. Furthermore, the precipitation temperature of the foreign metal during bonding can be decreased, and thus the further effect is provided which makes bonding in a low temperature possible.

The type of an amine compound is not particularly limited, and for example, primary amine compounds such as hexylamine, 2-ethylhexylamine, 2-(ethylhexyloxy)propylamine, dodecylamine, 3-(lauryloxy)propylamine, oleylamine and stearylamine, secondary amine compounds such as dipropylamine, diisopropylamine, methylhexylamine, dibutylamine, diisobutylamine and dicyclohexylamine, tertiary amine compounds such as tributylamine, N-methyldiethanolamine and N,N-dimethyldecylamine can be exemplified.

Other Components

The conductive paste according to the present embodiment may contain other components for enhancing properties of the conductive paste.

Silver Particle Having Second Average Particle Size

As the other components, for example, a silver particle having the second average particle size larger than the first average particle size described above can be exemplified as an inorganic particle. The average particle size in the present embodiment refers to the particle size at the cumulated volume of 50% in the particle size distribution (based on volume) measured by a laser diffraction method.

The second average particle size is not particularly limited as long as it is larger than the first average particle size used, but the particle size, for example, within the range of 0.1 μm to 10 μm is preferably used.

Similarly, the above silver particle of micro-order usually has a particle size distribution. For the silver particle having a second average particle size, a silver particle having a monodispersed particle size as highly as possible is preferably used, and specifically, the particle having a polydispersity defined below within a range of 0.5 to 10 is preferably used.

$$\text{Polydispersity} = (D90-D10)/D50 \text{ (wherein 5 nm} \leq D50 \leq$$

(wherein 5 nm ≤ D50 ≤ 500 nm)

D10: diameter (μm) of silver particle at cumulated volume of 10%

D50: diameter (μm) of silver particle at cumulated volume of 50%

D90: diameter (μm) of silver particle at cumulated volume of 90%

Effect Obtained by Mixing Silver Particles Having Different Particle Size

The conductive paste according to the present embodiment preferably contains a silver particle having a first average particle size and a silver particle having a second average particle size which is larger than the first average particle size. The silver particles having the first average particle size enter into spaces between the silver particles having the second average particle size. Thus, the porosity decreases and the packing ratio of the silver particle increases. Furthermore, the amount used of the silver particle having the first average particle size, which has a large amount of a solvent coating agent (coating film) formed on the silver particle surface, can be reduced. As a result, when the conductive paste according to the present embodiment is used for bonding of semiconductor element, a denser bonding layer can be obtained after sintering, and high bonding strength is achieved.

When the conductive paste according to the present embodiment is used for wiring forming, volume shrinkage after sintering is less and thus a thicker film can be formed, compared to the conductive paste using only the silver particle having the first average particle size. Such a thicker film can be applied to large current application.

The formulation ratio of the silver particle having the second average particle size and the silver particle having the first average particle size is preferably 10:90 to 60:40 in terms of a mass ratio. By this formulation ratio, the above-mentioned packing ratio of the silver particles enhances and thus denser bonding layer can be obtained after sintering.

Dispersing Agent

Other components are not particularly limited as long as properties of the conductive paste is not impaired, and for example, a dispersing agent having a functional group at terminal for stably dispersing particles in a dispersion may be contained. By containing a dispersing agent, functional groups of the dispersing agent are coordinated to a particle surface to prevent particles from coming close to each other, and thus reaggregation of particles can be suppressed to enhance dispersibility of particles.

A dispersing agent is not particularly limited, and for example, a cationic dispersing agent, anionic dispersing agent, nonionic dispersing agent, amphoteric dispersing agent, silicone-based dispersing agent, and fluorine-based dispersing agent can be used.

The conductive paste according to the present embodiment may contain a wet dispersing agent (antisettling agent) for preventing settling of a filler. By adding a wet dispersing agent, hardening of a precipitate (formation of a hard cake) can be prevented while retarding settling of a filler in the conductive paste. As result, by adding a wet dispersing agent, storage stability of the conductive paste to be obtained can be enhanced.

These dispersing agents form a molecular layer covering the metal particle surface to enhance dispersibility; however, the molecular layer preferably does not prevent the metal particles from coming into contact with each other at their surface in heat treatment for obtaining a sintered film. Specifically, a dispersing agent is preferably used which easily separates from the metal microparticle surface in heat treatment and has a boiling point within such range that the dispersing agent can be finally evaporated and removed.

The conductive paste according to the present embodiment may contain various solvents as other components. It is necessary to maintain the viscosity of the conductive paste according to the present embodiment within the desired range during its application process. Considering its handling property, a non-polar solvent or low-polar solvent which has relatively high boiling point and does not easily evaporate at around room temperature is preferably used as a solvent. Furthermore, a solvent preferably has heat stability to such an extent that the solvent is not decomposed by heat even at a temperature of heat treatment when the conductive metal paste is actually used.

The conductive metal paste according to the present embodiment is preferably prepared to have a suitable liquid viscosity for a drawing method to be adopted. For example, when screen printing method is used for drawing of micro-wiring pattern, the liquid viscosity of the conductive metal paste containing the silver particle is desirably selected to be within a range of 10 to 200 Pa.s (25°C). When inkjet printing method is used, the liquid viscosity is desirably selected to be within a range of 2 to 30 mPa.s (25°C). The liquid viscosity of the conductive paste depends the average particle size of the metal microparticle used, the concentration of a dispersion, and the type of dispersion medium used, and adjustment to the intended liquid viscosity can be achieved by appropriately selecting the above three factors.

Examples

Solubility of Foreign Metal

An Example for confirming that a foreign metal is easily solubilized in the system by using an amine compound will be described below.

As a foreign metal, each of copper (II) acetate (manufactured by FUJIFILM Wako Pure Chemical Corporation), manganese (II) acetate (manufactured by FUJIFILM Wako Pure Chemical Corporation) and copper (II) 2-ethylhexanoate (manufactured by Mitsuwa Chemicals Co., Ltd.) was added to tetradecane (manufactured by JXTG Nippon Oil & Energy Corporation), which is a non-polar solvent, and as a result, none of them did not dissolve in tetradecane. Thenrefore, each of 2-(ethylhexyloxy)propylamine (manufactured by Koei Chemical Co., Ltd.) or hexylamine (manufactured by Tokyo Chemical Industry Co., Ltd.) as a primary amine, dibutylamine (manufactured by Koei Chemical Co., Ltd.) as a secondary amine and N-methyldiethanolamine (manufactured by Tokyo Chemical Industry Co., Ltd.) as a tertiary amine was added. The above amine compound was added in such an amount that the amount of substance of the amine compounds was equal to the amount of substance of the foreign metal.

As a result, only in the case where dibutylamine as a secondary amine was added to the system in which manganese acetate was added to tetradecane, the foreign metal did not dissolve completely and only a part of the foreign metal dissolved. In other combinations, it was confirmed that the foreign metal dissolved completely.

Examples 1 - 14 and Comparative Example 1

The following materials were provided as the materials of the conductive pastes.

Silver particle 1 having first average particle size: commercially available ultrafine particle dispersion of silver (product name: independently dispersed ultrafine particle Ag1T: manufactured by ULVAC, Inc., average particle size 5 nm),

Silver particle 2 having first average particle size: silver microparticle (manufactured by SHOEI CHEMICAL INC., product name: AG-202, average particle size 250 nm),

Foreign metal (salt) 1: mineral spirit solution of manganese(II) 2-ethylhexanoate (manufactured by FUJIFILM Wako Pure Chemical Corporation, Mn: 8 mass%),

Foreign metal (salt) 2: zirconium(IV) octanoate (manufactured by Mitsuwa Chemicals Co., Ltd., Zr: 13.5 mass%),

Foreign metal (salt) 3: chromium(III) 2-ethylhexanoate (manufactured by Strem Chemicals, Inc., Cr: 9 mass%),

Foreign metal (salt) 4: aluminum(III) 2-ethylhexanoate (manufactured by NAKALAI TESQUE, INC., Al: 8.2 mass%),

Foreign metal (salt) 5: titanium(IV) 2-ethylhexanoate (manufactured by Kusumoto Chemicals, Ltd., Ti: 7.7 mass%),

Foreign metal (salt) 6: copper(II) 2-ethylhexanoate (manufactured by Mitsuwa Chemicals Co., Ltd., Cu: 18.2 mass%),

Foreign metal (salt) 7: zinc(II) 2-ethylhexanoate (manufactured by FUJIFILM Wako Pure Chemical Corporation, Zn: 15.0 mass%),

Foreign metal (salt) 8: indium(III) acetate (manufactured by FUJIFILM Wako Pure Chemical Corporation, In: 39.3 mass%),

Foreign metal (salt) 9: tin(II) 2-ethylhexanoate (manufactured by FUJIFILM Wako Pure Chemical Corporation, Sn: 29.3 mass%),

Foreign metal (salt) 10: bismuth(II) 2-ethylhexanoate (manufactured by Strem Chemicals, Inc., Bi: 32.7 mass%),

Foreign metal (salt) 11: rhodium(II) acetate (manufactured by Tokyo Chemical Industry Co., Ltd., Ru: 46.6 mass%),

Foreign metal (salt) 12: acethylacetone ruthenium(III) (manufactured by Tokyo Chemical Industry Co., Ltd., Rh: 25.4 mass%),

Foreign metal (salt) 13: palladium(II) acetate (manufactured by FUJIFILM Wako Pure Chemical Corporation, Pd: 47.4 mass%),

Solvent 1: AF7 solvent (manufactured by JXTG Nippon Oil & Energy Corporation, distillation temperature 260 to 278°C),

The solvent was distilled off under a reduced pressure from a dispersion of the silver microparticle having an average particle size of 5 nm, the dispersion including 35 parts by mass of the silver microparticle, 7 parts by mass of dodecylamine (molecular weight 185.36) as an alkylamine and 58 parts by mass of toluene (boiling point 110.6°C) as an organic solvent, or from the above silver microparticle dispersion, to obtain a slurry of silver microparticle. This slurry was subjected to a measurement of the mass loss by increasing the temperature to 500°C using a thermal analysis apparatus, and the silver content was calculated from the mass loss. As a result, the silver content of the obtained slurry was 83.3%.

To the above-mentioned slurry, a foreign metal salt and the solvent was added, and the slurry was mixed for 60 seconds by an agitation defoaming apparatus (manufactured by KURABO INDUSTRIES LTD., product name: KK-V300, rotation: 720 rpm, revolution: 935 rpm) to obtain a conductive paste. In the case where a foreign metal salt was used, the amount of each foreign metal salt relative to the mass of silver in the conductive paste was calculated, and the foreign metal salt was added in an amount shown in Table 1 below.

The conductive pastes were made according to formulations shown in Table 1 with regard to the amount of each material. The conductive paste of Formulation 1 is a comparative example, and the conductive pastes of Formulation 2 to 15 are examples. The conductive pastes of Formulation 1 to 15 were each applied to a nickel plate and sintered to form a sintered film, and tape peeling tests and evaluations were conducted for the sintered film, as described in the evaluation method of bondability described below. The evaluation results are also shown in Table 1.

Examples 15 - 30 and Comparative Examples 2 - 3

The following materials were provided as the materials of the conductive pastes.

Silver particle 3 having first average particle size: silver microparticle (manufactured by SHOEI CHEMICAL INC., product name: AG-202, average particle size 250 nm),

Silver particle 1 having second average particle size: silver powder (manufactured by DOWA Electronics Materials Co., Ltd., product name: Ag-2-1C, average particle size 1.0 ($\mu$m),

Silver particle 2 having second average particle size: silver powder (manufactured by TOKURIKI HONTEN CO., LTD., product name: TC-506C, average particle size 4.0 $\mu$m),

Dispersing agent 1: 2-ethylhexyloxy propylamine (manufactured by KOEI Chemical Co., LTD., molecular weight 187.32),

Dispersing agent 2: neodecanoic acid (manufactured by Hexion Specialty Chemicals Inc., molecular weight 172.26),

Foreign metal (salt) 14: mineral spirit solution of manganese(II) 2-ethylhexanoate (manufactured by FUJIFILM Wako Pure Chemical Corporation, Mn amount: 8 mass%),

Foreign metal (salt) 15: zirconium(IV) octanoate (manufactured by Mitsuwa Chemicals Co., Ltd., Zr amount: 13.5 mass%),

Foreign metal (salt) 16: chromium(III) 2-ethylhexanoate (manufactured by Strem Chemicals, Inc., Cr amount: 9 mass%),

Foreign metal (salt) 17: aluminum(II) 2-ethylhexanoate (manufactured by NAKALAI TESQUE, INC., Al amount: 8.2 mass%),

Foreign metal (salt) 18: titanium(IV) 2-ethylhexanoate (manufactured by Kusumoto Chemicals, Ltd., Ti amount: 7.7 mass%),

Foreign metal (salt) 19: copper(II) 2-ethylhexanoate (manufactured by Mitsuwa Chemicals Co., Ltd., Cu amount: 18.2 mass%),

Foreign metal (salt) 20: mineral spirit solution of zinc(II) 2-ethylhexanoate (manufactured by FUJIFILM Wako Pure Chemical Corporation, Zn amount: 15.0 mass%),

Foreign metal (salt) 21: indium(III) acetate (manufactured by FUJIFILM Wako Pure Chemical Corporation, In amount: 39.3 mass%),

Foreign metal (salt) 22: tin(II) 2-ethylhexanoate (manufactured by FUJIFILM Wako Pure Chemical Corporation, Sn amount: 29.3 mass%),

Foreign metal (salt) 23: bismuth(II) 2-ethylhexanoate (manufactured by FUJIFILM Wako Pure Chemical Corporation, Bi amount: 32.7 mass%),

Foreign metal (salt) 24: acethylacetone ruthenium(III) (manufactured by Tokyo Chemical Industry Co., Ltd., Ru amount: 46.6 mass%),

Foreign metal (salt) 25: rhodium(II) acetate (manufactured by Tokyo Chemical Industry Co., Ltd., Rh amount: 46.6 mass%),

Foreign metal (salt) 26: palladium(II) acetate (manufactured by FUJIFILM Wako Pure Chemical Corporation, Pd amount: 47.4 mass%),

Foreign metal (salt) 27: manganese(II) acetate (manufactured by FUJIFILM Wako Pure Chemical Corporation, Mn amount: 31.8 mass%),

Solvent 2: hexyl carbitol (molecular weight 190.28, boiling point 258°C) .

A silver particle having the second average particle size and a solvent were added to the above dispersing agent, and the resultant was mixed for 30 seconds by an agitation defoaming apparatus (manufactured by KURABO INDUSTRIES LTD., product name: KK-V300, rotation: 720 rpm, revolution: 935 rpm).

To the mixture, a silver particle having the first average particle size and a foreign metal (if used) were added, and then the resultant was further mixed for 60 seconds by the agitation defoaming apparatus to obtain a conductive paste. In the case where a foreign metal is used, the amount of the foreign metal salt relative to the mass of silver in the conductive paste was calculated, and the foreign metal salt was added in an amount listed in Table 2 below. In the case where a foreign metal salt including a mineral spirit solution was added, the mineral spirit solution was removed from the solution to form a paste (slurry) by the method described below, and the obtained paste was added. The preparation method in the case of using a mineral spirit solution of manganese(II) 2-ethylhexanoate is described below.

In a 500 mL eggplant flask, 30 g of mineral spirit solution of manganese (II) 2-ethylhexanoate and 150 g of acetonitrile were placed. The mixture was stirred for 3 minutes at room temperature and left to stand to precipitate manganese(II) 2-ethylhexanoate on a bottom of a container, and then a supernatant layer was removed. To the slurry obtained by further conducting the same operation twice to remove supernatant layers, 6 g of hexyl carbitol was added, and the resultant was concentrated under the reduced pressure of 30 hPa at 50°C to distill off the remained acetonitrile, thereby obtaining a slurry of manganese(II) 2-ethylhexanoate. Furthermore, the obtained slurry was filtered with a 250 mesh filter, and then subjected to a measurement of the mass loss by increasing the temperature to 500°C using a thermal analysis apparatus (manufactured by SII Nano Technology Inc., product name: TG/DTA6200), and the manganese content was calculated from the mass loss determined from the product after sintering at 500°C. As a result, the manganese content of the obtained slurry was 16.1%.

The conductive pastes were made according to formulations shown in Table 2 with regard to the amount of each material. The conductive pastes of Formulations 16 and 17 are comparative examples, the conductive pastes of Formulations 18 to 33 are examples.

Evaluation of bondability

Evaluation tests of bondability to substrates were conducted for the conductive pastes obtained in examples and comparative examples according to the following method.

To nickel plates (manufactured by Nippon Yakin Kogyo Co., Ltd., purity 99%), conductive pastes obtained in examples and comparative examples were respectively applied in the specified amount. Then, the metal plates with the conductive paste applied were heated in the atmosphere at 300°C for 60 minutes using an air dryer (manufactured by ESPEC CORP., product name: STH-120) to sinter the conductive paste. The amount of the conductive paste applied was set so that the thickness of a film of the conductive paste after sintering (hereinafter, sintered film) was 15 μm.

Evaluations of bondability of the sintered film to the nickel plate were conducted by a tape peeling test. For the sintered films obtained from the formulations of examples, the sintered films were adhered to the nickel plates with a part of the sintered film adhering to the tape or without adhesion of the sintered film to the tape. In contrast, for the sintered films obtained from the formulations of comparative examples, the sintered films were adhered to tapes and thus it was confirmed that at least a part of the sintered film was peeled off from the nickel plate.

Evaluation results: ◎: sintered film was not peeled off, ○: a part of sintered film was peeled off, ×: sintered film was completely peeled off

For some of the conductive pastes obtained examples and comparative examples, a copper plate and a silicon chip (5 mm$^2$) with sputtered titanium and nickel plating in this order from the silicon were bonded via the conductive paste by pressurizing at 10 MPa at 300°C for 30 minutes under a nitrogen atmosphere. For the obtained bonded articles, the shear strength of the silicon chip was measured.

The examples of formulation and the evaluation results are shown in Table 1 and Table 2.

[Table 1]

| | | Comparative Example 1 | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|---|
| | | Formulation 1 | Formulation 2 | Formulation 3 | Formulation 4 | Formulation 5 | Formulation 6 | Formulation 7 | Formulation 8 | Formulation 9 | Formulation 10 | Formulation 11 | Formulation 12 | Formulation 13 | Formulation 14 | Formulation 15 |
| Amount formulated | Silver particle 1 having first average particle size / g | 84.0 | - | 84.0 | 84.0 | 84.0 | 84.0 | 84.0 | 84.0 | 84.0 | 84.0 | 84.0 | 84.0 | 84.0 | 84.0 | 84.0 |
| | Silver particle 2 having first average particle size / g | - | 70.0 | - | - | - | - | - | - | - | - | - | - | - | - | - |
| | Foreign metal 1 / g | - | 0.4 | - | - | - | - | - | - | - | - | - | - | - | - | 4.3 |
| | Foreign metal 2 / g | - | - | 0.3 | - | - | - | - | - | - | - | - | - | - | - | - |
| | Foreign metal 3 / g | - | - | - | 0.6 | - | - | - | - | - | - | - | - | - | - | - |
| | Foreign metal 4 / g | - | - | - | - | 0.9 | - | - | - | - | - | - | - | - | - | - |
| | Foreign metal 5 / g | - | - | - | - | - | 09 | - | - | - | - | - | - | - | - | - |
| | Foreign metal 6 / g | - | - | - | - | - | - | 04 | - | - | - | - | - | - | - | - |
| | Foreign metal 7 / g | - | - | - | - | - | - | - | 0.4 | - | - | - | - | - | - | - |
| | Foreign metal 8 / g | - | - | - | - | - | - | - | - | 0.2 | - | - | - | - | - | - |

(continued)

| | Comparative Example 1 | Example 1 | Example 2 | Example 3 | Example 4 | Example 5 | Example 6 | Example 7 | Example 8 | Example 9 | Example 10 | Example 11 | Example 12 | Example 13 | Example 14 |
|---|---|---|---|---|---|---|---|---|---|---|---|---|---|---|---|
| | Formulation 1 | Formulation 2 | Formulation 3 | Formulation 4 | Formulation 5 | Formulation 6 | Formulation 7 | Formulation 8 | Formulation 9 | Formulation 10 | Formulation 11 | Formulation 12 | Formulation 13 | Formulation 14 | Formulation 15 |
| Foreign metal 9 / g | - | - | - | - | - | - | - | - | - | 0.2 | - | - | - | - | - |
| Foreign metal 10 / g | - | - | - | - | - | - | - | - | - | - | 0.2 | - | - | - | - |
| Foreign metal 11 / g | - | - | - | - | - | - | - | - | - | - | - | 0.3 | - | - | - |
| Foreign metal 12 / g | - | - | - | - | - | - | - | - | - | - | - | - | 0.3 | - | - |
| Foreign metal 13 / g | - | - | - | - | - | - | - | - | - | - | - | - | - | 0.1 | - |
| Solvent 1 / g | 16.0 | 29.6 | 15.7 | 15.4 | 15.1 | 15.1 | 15.6 | 15.6 | 15.8 | 15.8 | 15.8 | 15.7 | 15.7 | 15.9 | 11.7 |
| Evaluation of bondability | Tape peeling test Nickel plate | × | ○ | ◎ | ◎ | ○ | ○ | ◎ | ○ | ○ | ○ | ○ | ○ | ○ | ○ | ◎ |

11

[Table 2]

| | | | Comparative Example 2 | Comparative Example 3 | Example 15 | Example 16 | Example 17 | Example 18 | Example 19 | Example 20 | Example 21 | Example 22 | Example 23 | Example 24 | Example 25 | Example 26 | Example 27 | Example 28 | Example 29 | Example 30 |
|---|---|---|---|---|---|---|---|---|---|---|---|---|---|---|---|---|---|---|---|---|
| | | | Formulation 16 | Formulation 17 | Formulation 18 | Formulation 19 | Formulation 20 | Formulation 21 | Formulation 22 | Formulation 23 | Formulation 24 | Formulation 25 | Formulation 26 | Formulation 27 | Formulation 28 | Formulation 29 | Formulation 30 | Formulation 31 | Formulation 32 | Formulation 33 |
| Amount formulated | | Silver particle 3 having first average particle size / g | 12.9 | 86.0 | 12.9 | 12.9 | 12.9 | 12.9 | 12.9 | 12.9 | 12.9 | 12.9 | 12.9 | 12.9 | 12.9 | 12.9 | 12.9 | 12.9 | 12.9 | 9.9 |
| | | Silver particle 1 having second average particle size / g | 54.9 | — | 54.8 | 54.8 | 54.8 | 54.8 | 54.8 | 54.8 | 54.8 | 54.8 | 54.8 | 54.8 | 54.8 | 54.8 | 54.8 | 54.8 | 54.8 | 42.1 |
| | | Silver particle 2 having second average particle size / g | 18.3 | — | 18.3 | 18.3 | 18.3 | 18.3 | 18.3 | 18.3 | 18.3 | 18.3 | 18.3 | 18.3 | 18.3 | 18.3 | 18.3 | 18.3 | 18.3 | 14.0 |
| | | Foreign metal 14 / g | 0.0 | 0.5 | 0.05 | 0.5 | — | — | — | — | — | — | — | — | — | — | — | — | 5.3 | — |
| | | Foreign metal 15 / g | — | — | — | — | 0.4 | — | — | — | — | — | — | — | — | — | — | — | — | — |
| | | Foreign metal 16 / g | — | — | — | — | — | 0.8 | — | — | — | — | — | — | — | — | — | — | — | — |
| | | Foreign metal 17 / g | — | — | — | — | — | — | 1.1 | — | — | — | — | — | — | — | — | — | — | — |
| | | Foreign metal 18 / g | — | — | — | — | — | — | — | 0.5 | — | — | — | — | — | — | — | — | — | — |
| | | Foreign metal 19 / g | — | — | — | — | — | — | — | — | 0.5 | — | — | — | — | — | — | — | — | — |
| | | Foreign metal 20 / g | — | — | — | — | — | — | — | — | — | 0.2 | — | — | — | — | — | — | — | — |
| | | Foreign metal 21 / g | — | — | — | — | — | — | — | — | — | — | 0.2 | — | — | — | — | — | — | — |
| | | Foreign metal 22 / g | — | — | — | — | — | — | — | — | — | — | — | 0.3 | — | — | — | — | — | — |
| | | Foreign metal 23 / g | — | — | — | — | — | — | — | — | — | — | — | — | 0.3 | — | — | — | — | — |
| | | Foreign metal 24 / g | — | — | — | — | — | — | — | — | — | — | — | — | — | 0.4 | — | — | — | — |
| | | Foreign metal 25 / g | — | — | — | — | — | — | — | — | — | — | — | — | — | — | 0.3 | — | — | — |
| | | Foreign metal 26 / g | — | — | — | — | — | — | — | — | — | — | — | — | — | — | — | 0.2 | — | — |
| | | Foreign metal 27 / g | — | — | — | — | — | — | — | — | — | — | — | — | — | — | — | — | — | 10.4 |
| | | Dispersing agent 1 / g | 3.9 | 3.9 | 3.9 | 3.9 | 3.9 | 3.9 | 3.9 | 3.9 | 3.9 | 3.9 | 3.9 | 3.9 | 3.9 | 3.9 | 3.9 | 3.9 | 3.9 | 11.2 |
| | | Dispersing agent 2 / g | 3.6 | 3.6 | 3.6 | 3.6 | 3.6 | 3.6 | 3.6 | 3.6 | 3.6 | 3.6 | 3.6 | 3.6 | 3.6 | 3.6 | 3.6 | 3.6 | 3.6 | 10.3 |
| | | Solvent 2 / g | 6.5 | 6.0 | 6.5 | 6.0 | 6.2 | 5.8 | 5.5 | 6.1 | 6.1 | 6.4 | 6.4 | 6.3 | 6.3 | 6.2 | 6.3 | 6.4 | 1.2 | 2.1 |
| Evaluation of bondability | Tape peeling test | Nickel plate | × | ○ | ◎ | ◎ | ◎ | ◎ | ○ | ○ | ◎ | ○ | ○ | ○ | ○ | ○ | ○ | ◎ | ○ | ○ |
| | Shear strength | Bonding of silicon chip having nickel plating and copper plate | 0 MPa (peeled off) | 0 MPa (peeled off) | 9.8MPa | 40MPa | 40MPa | 40MPa | 28MPa | 22MPa | 40MPa | 18MPa | 32MPa | 28MPa | 27MPa | 25MPa | 22MPa | 36MPa | 28MPa | 12MPa |

12

From these results, when the conductive paste according to the present embodiment has one or more metals selected from a group consisting of aluminum, titanium, vanadium, chromium, manganese, iron, cobalt, nickel, copper, zinc, zirconium, niobium, molybdenum, hafnium, tantalum, tungsten, indium, tin, gallium, germanium and bismuth, the conductive paste has high bondability to even a substrate which has low bondability to silver. These metals were used as metals which satisfy at least one or more criteria of the three criteria below: Criterion 1: An element which mutually diffuses (form a solid solution or intermetallic compound) with both a substrate and silver; Criterion 2: An element which has a lower standard potential than a substrate and is capable of forming an alloy with silver; Criterion 3: Elements including a first element having a lower standard potential than a substrate, and a second element group having a standard potential between the standard potentials of silver and the first element, wherein the second element is capable of forming an alloy with both silver and the first element. Even in the case of metals which have not been evaluated in examples, since the metal satisfies one or more criteria of the above criteria 1 to 3, the same effect to that of evaluated metals is obtained.

The conductive paste according to the present embodiment has a silver particle having a first average particle size and a silver particle having a second average particle size which is larger than the first average particle size. The silver particles having the first average particle size enter into spaces between the silver particles having the second average particle size. Thus, the porosity decreases and the packing ratio of the silver particle increases. Furthermore, the amount used of the silver particle having the first average particle size, which has a large amount of a solvent coating agent formed on the silver particle surface, can be reduced. As a result, when the conductive paste according to the present embodiment is used for bonding of semiconductor element, a denser bonding layer can be obtained after sintering, and high bonding strength is achieved.

The above description is merely illustrative examples, and the present invention is not limited to the constitutions of the above embodiments.

**Claims**

1. A conductive paste comprising:

   a silver particle having an average particle size within a range of 1 to 500 nm as a first average particle size;
   one or more metals selected from a group consisting of aluminum, titanium, vanadium, chromium, manganese, iron, cobalt, nickel, copper, zinc, zirconium, niobium, molybdenum, hafnium, tantalum, tungsten, indium, tin, gallium, germanium and bismuth; and
   an amine compound,
   wherein an amount of substance of the amine compound is equal to or more than an amount of substance of the metal.

2. The conductive paste according to claim 1, further comprising a silver particle having a second average particle size larger than the first average particle size.

3. The conductive paste according to claim 2, wherein the second average particle size is within a range of 0.1 $\mu$m to 10 $\mu$m.

4. The conductive paste according to claim 1, wherein the metal is present in one or more forms selected from a group consisting of a particle, a metal oxide, a metal salt and an organic metal complex, in the conductive paste.

5. The conductive paste according to claim 1, wherein a mass of the metal in the conductive paste is within a range of 0.001 to 5 mass% based on a mass of silver.

6. A sintered film obtained by heat-treating the conductive paste according to claim 1.

Figure 1

Figure 2

Figure 3

Figure 4

Figure 5

Figure 6

| Electrode reaction | Standard potential (V) 25°C | Ionization tendency |
|---|---|---|
| $Au^{3+}+3e^-=Au$ | 1.5 | Au |
| $Pt^{2+}+2e^-=Pt$ | 1.2 | Pt |
| $Pd^{2+}+2e^-=Pd$ | 0.987 | |
| $Hg^{2+}+2e^-=Hg$ | 0.854 | Hg |
| $Ag^++e^-=Ag$ | 0.8 | Ag |
| $Hg_2^{2+}+2e^-=2Hg$ | 0.789 | |
| $Cu^++e^-=Cu$ | 0.521 | Cu |
| $Cu^{2+}+2e^-=Cu$ | 0.337 | |
| $H^++2e^-=H2$ | 0 | H |
| $Pb^{2+}+2e^-=Pb$ | −0.126 | Pb |
| $Sn^{2+}+2e^-=Sn$ | −0.136 | Sn |
| $Mo^{3+}+3e^-=Mo$ | −0.2 | |
| $Ni^{2+}+2e^-=Ni$ | −0.25 | Ni |
| $Co^{2+}+2e^-=Co$ | −0.277 | |
| $Cd^{2+}+2e^-=Cd$ | −0.403 | Cd |
| $Fe^{2+}+2e^-=Fe$ | −0.44 | Fe |
| $Cr^{3+}+3e^-=Cr$ | −0.74 | |
| $Cr^{2+}+2e^-=Cr$ | −0.91 | |
| $Zn^{2+}+2e^-=Zn$ | −0.763 | Zn |
| $Mn^{2+}+2e^-=Mn$ | −1.18 | |
| $Zr^{4+}+4e^-=Zr$ | −1.53 | |
| $Ti^{2+}+2e^-=Ti$ | −1.63 | |
| $Al^{3+}+3e^-=Al$ | −1.66 | Al |
| $Be^{2+}+2e^-=Be$ | −1.85 | |
| $Mg^{2+}+2e^-=Mg$ | −2.37 | Mg |
| $Na^++e^-=Na$ | −2.71 | Na |
| $Ca^{2+}+2e^-=Ca$ | −2.87 | Ca |
| $K^++e^-=K$ | −2.93 | K |
| $Li^++e^-=Li$ | −3.05 | |

## INTERNATIONAL SEARCH REPORT

| International application No. |
|---|
| PCT/JP2018/036253 |

**A. CLASSIFICATION OF SUBJECT MATTER**
Int.Cl. H01B1/22(2006.01)i,     H01B1/00(2006.01)i,     H01L21/288(2006.01)i,     H05K1/09(2006.01)i

According to International Patent Classification (IPC) or to both national classification and IPC

**B. FIELDS SEARCHED**

Minimum documentation searched (classification system followed by classification symbols)
Int.Cl. H01B1/22, H01B1/00, H01L21/288, H05K1/09

| Documentation searched other than minimum documentation to the extent that such documents are included in the fields searched | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2016/076306 A1 (HARIMA CHEMICALS, INC.) 19 May 2016, table 7, treatment 38, paragraphs [0023], [0046], claims 1-2 (Family: none) | 1,4 6<br>5 |
| X<br>A | WO 2006/011180 A1 (HARIMA CHEMICALS, INC.) 02 February 2006, example 2, paragraph [0084] & US 2008/0105853 A1 paragraph [0092] | 1, 4-6<br>2-3 |
| X | JP 2012-131894 A (TOSOH CORP.) 12 July 2012, claim 3, example 1, paragraphs [0058], [0116], [0065] (Family: none) | 1-6 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05 December 2018 (05.12.2018) | 08 January 2019 (08.01.2019) |

| Name and mailing address of the ISA/<br>Japan Patent Office<br>3-4-3, Kasumigaseki, Chiyoda-ku,<br>Tokyo 100-8915, Japan | Authorized officer |
|---|---|
| | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012119132 A